(19) Europäisches Patentamt
European Patent Office
Office européen des brevets

(11) Publication number: 0 037 227
B1

(12) EUROPEAN PATENT SPECIFICATION

(45) Date of publication of patent specification: 25.09.85

(51) Int. Cl.4: G 11 C 11/24, G 11 C 7/00, G 11 C 5/02

(21) Application number: 81301226.7

(22) Date of filing: 23.03.81

# (54) Semiconductor memory device.

(30) Priority: 28.03.80 JP 39892/80
28.03.80 JP 39893/80

(43) Date of publication of application:
07.10.81 Bulletin 81/40

(45) Publication of the grant of the patent:
25.09.85 Bulletin 85/39

(84) Designated Contracting States:
DE FR GB NL

(56) References cited:
EP-A-0 037 233

THE SEMICONDUCTOR MEMORY BOOK, 1978, pages 131-138, John Wiley + Sons, New York (USA); J.COE : "Designing with 16K dynamic Rams.
IEEE INTERNATIONAL SOLID-STATE CIRCUITS CONFERENCE, vol. 23, February 1980, pages 66-67, New York (USA); OHTA et al.: " A stacked high capacitor ram ."

(73) Proprietor: FUJITSU LIMITED
1015, Kamikodanaka Nakahara-ku
Kawasaki-shi Kanagawa 211 (JP)

(72) Inventor: Nakano, Tomio
1-11-2-12-404, Shirahatadai Takatsu-ku
Kawasaki-shi Kanagawa 213 (JP)

(74) Representative: George, Sidney Arthur et al
GILL JENNINGS & EVERY 53-64 Chancery Lane
London WC2A 1HN (GB)

(56) References cited:
IEEE JOURNAL OF SOLID-STATE CIRCUITS, vol. SC-13, no. 5, October 1978, pages 607-610, New York (USA); WADA et al.: "A 150ns, 150mW, 64K dynamic MOS RAM."
IEEE INTERNATIONAL SOLID-STATE CIRCUITS CONFERENCE, vol. 22, February 1979, pages 146-147, New York (USA); LEE et al.: " A 64Kb MOS dynamic RAM".
IBM TECHNICAL DISCLOSURE BULLETIN, vol. 21, no. 6, November 1978, pages 2257-2259, New York (USA); R.M.GEFFKEN et al.: " Process for high-capacitance single-device memory cell".

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 037 227 B1

IEEE International Solid-State Circuits Conference, Vol. 23, Feb. 1980, pages 66-67, New York (US), OHTA et al.: "A stacked high capacitor RAM"

**Description**

This invention relates to a semiconductor memory device, and more particularly to a dynamic type semiconductor RAM device having a large memory capacity in which the structure is improved so that a greater portion of a chip area can be used for forming memory cells.

Figure 1 of the accompanying drawings illustrates an arrangement of circuit components on a semiconductor chip of a conventional MOS dynamic type RAM device having a small or medium memory capacity, for example 4 Kbits or 16 Kbits. In the RAM device of Figure 1, sense amplifiers $SA_1$ to $SA_n$ are arranged in a line at the centre of the semiconductor chip, and a plurality of memory cells, each comprising an MOS transistor and a capacitor, are divided into two cell groups, $CG_1$ and $CG_2$ which are arranged on both sides of the sense amplifiers. The RAM device of Figure 1 has a memory capacity of $n \times m$ bits and each of the cell groups $CG_1$ and $CG_2$ has $n \times m/2$ memory cells. In the area of the cell group $CG_1$, there are arranged m/2 row lines or word lines RL which are connected to and selected by row decoders RD and which extend in the transverse direction in Figure 1, and n digit lines DG each of which is connected to one of a pair of input/output terminals of the sense amplifiers $SA_1$ to $SA_n$ and which extend in the longitudinal direction in Figure 1. In the area of the cell group $CG_2$, there are also arranged m/2 row lines or word lines RL which are connected to and selected by the row decoders RD and which extend in the transverse direction in Figure 1, and n digit lines $\overline{DG}$ each of which is connected to another one of the pair of the input/output terminals of the sense amplifiers $SA_1$ to $SA_n$ and which extend in the longitudinal direction in Figure 1. At each cross point of one of the row lines RL and one of the digit lines DG or $\overline{DG}$, there is disposed the memory cell MC. In each of the areas of the cell groups $CG_1$ and $CG_2$, a dummy word line DRL is respectively disposed and at each one of the cross points between the dummy word lines DRL and the digit lines DG and $\overline{DG}$, a dummy memory cell (hereinafter referred to as a dummy cell) DC is respectively disposed. In Figure 1, only one of the memory cells MC and only one of the dummy cells DC are illustrated and illustration of the other memory cells and the dummy cells is omitted. When, for example, a "real" memory cell MC connected to the digit line DG, which is connected to the sense amplifier $SA_i$, is selected in the first cell group $CG_1$, a dummy cell DC connected to the digit line $\overline{DG}$ which is connected to the same sense amplifier $SA_i$ is selected in the second cell group $CG_2$. Therefore, Figure 1 illustrates the memory cell MC and the dummy cell DC which are selected at the same time. Although they are not shown in Figure 1, a pair of bus lines are disposed on both sides of an array of the sense amplifiers $SA_1$ through $SA_n$ and an output signal from each of the sense amplifiers $SA_1$ through $SA_n$ is derived through the pair of bus lines. The connection between the bus lines and the digit lines DG and $\overline{DG}$, and therefore the selection of one of the sense amplifiers $SA_i$ $(i=1, 2, \ldots, n)$, is effected by column decoders CD. The column decoders CD are divided into two half groups and disposed on both sides of the sense amplifiers $SA_1$ through $SA_n$, i.e., on the sides of the digit line DG and the digit line $\overline{DG}$, in order to keep a symmetry in the electrical characteristic of the sense amplifier circuits.

Figure 2 illustrates a detailed circuit of a part of the memory device of Figure 1. As illustrated in Figure 2, the memory cell MC comprises an MOS transistor $Q_1$ which is turned on when the word line RL is selected and the potential of the word line RL is high, and a capacitor $C_S$ connected between the source electrode of the MOS transistor $Q_1$ and the ground. The dummy cell DC comprises an MOS transistor $Q_1'$ which is turned on when the dummy word line DRL is selected and the potential of the dummy word line DRL is high, a capacitor $C_S'$ which is connected between the source electrode of the MOS transistor $Q_1'$ and the ground and whose capacitance is approximately equal to half of that of the capacitor $C_S$ of the memory cell MC, and an MOS transistor $Q_4$ which is turned on by a reset signal RST and which discharges the electric charge of the capacitor $C_S'$ before the read-out of information from the memory cell MC is effected.

The read-out of information from the memory cell MC is started, as is well known, from precharging the digit lines DG and $\overline{DG}$. Then, one of the word lines RL and one of the dummy word lines DRL are selected by the row decoder RD and the transistor $Q_1$ of the memory cell MC connected to the selected word line RL and the transistor $Q_1'$ of the dummy cell DC connected to the selected dummy word line DRL are both turned on, so that the capacitor $C_S$ and $C_S'$ of the selected memory cell MC and dummy cell DC are connected to the digit lines DG and $\overline{DG}$, respectively. Since the capacitor $C_S'$ of the dummy cell DC is previously discharged by the transistor $Q_4$, the potential of the digit line $\overline{DG}$ slightly falls after the above-mentioned connection is effected. On the other hand, the potential of the digit line DG falls greatly when the capacitor $C_S$ of the real cell MC is not charged i.e., when the information "0" is written in to the real cell MC, because the capacitance of the capacitor $C_S$ is larger than that of the capacitor $C_S'$. When the capacitor $C_S$ is charged, i.e., when the information "1" is written in to the real cell MC, the potential of the digit line DG does not change, because the potential of the precharged digit line DG is equal to that of the capacitor $C_S$. The sense amplifier SA detects and amplifies the potential difference between the digit lines DG and $\overline{DG}$, and the output from the sense amplifier SA appears on the same digit lines DG and $\overline{DG}$ so that the potential difference between the digit lines DG and $\overline{DG}$ is increased. Then transistors $Q_2$ and $Q_3$ are both turned on by the column decoder CD and the digit lines DG and $\overline{DG}$ are respectively connected to the bus lines BUS and $\overline{BUS}$ so that the potentials of the bus

lines BUS and $\overline{BUS}$ are equal to those of the digit lines DG and $\overline{DG}$, respectively. An input/output amplifier IOA amplifies the potentials of the bus lines BUS and $\overline{BUS}$ and generates a read-out signal $D_{OUT}$ from the memory cell MC.

The write-in of information to the selected memory cell MC is effected by applying a write-in signal $D_{IN}$ to the input/output amplifier IOA. According to the high or low level of the write-in signal $D_{IN}$, the potentials of the bus lines BUS and $\overline{BUS}$ become, for example, high and low or low and high, respectively, and the potentials of the digit lines DG and $\overline{DG}$ follow the potentials of the bus lines BUS and $\overline{BUS}$ when the transistors $Q_2$ and $Q_3$ are turned on. Then the transistor $Q_1$ of the selected memory cell MC is turned on by the high level signal applied to the word line RL and the capacitor $C_S$ of the selected memory cell MC is charged, i.e., the write-in of information is effected.

Figure 3 illustrates an example of a structure of the above-mentioned dynamic-type semiconductor RAM device having the memory cells each of which comprises a transistor and a capacitor. The dynamic-type RAM device of Figure 3 has what is called a two polysilicon layer structure which uses a first polycrystalline silicon (hereinafter referred to as polysilicon) layer $P_1$ and a second polysilicon layer $P_2$. The device of Figure 3 has a three-layer structure and comprises the polysilicon layer $P_1$ formed on a silicon semiconductor substrate (not shown in the drawing) through a gate oxide layer or a field oxide layer formed therebetween, the polysilicon layer $P_2$ formed on the polysilicon layer $P_1$ through an insulation layer formed therebetween and formed on the silicon semiconductor substrate through a gate oxide layer formed therebetween, and, row lines RL as a third layer formed on the polysilicon layer $P_2$ through an insulation layer formed therebetween. The third layer, i.e., the row lines RL each of which is connected to the second layer $P_2$ at a contact hole $CH_1$, is made of aluminum. In Figure 3, a plan view of two bit memory cells is shown, and each one of the memory cells is constituted by an MOS transistor $Q_{11}$ or $Q_{12}$ and an MOS capacitor $C_1$ or $C_2$. On fishtail shaped areas $AR_1$ and $AR_2$, which constitue parts of the transistors $Q_{11}$ and $Q_{12}$, respectively, and the capacitors $C_1$ and $C_2$, respectively, a thin gate oxide layer is formed and these areas $AR_1$ and $AR_2$ are separated by a thick field oxide layer. Therefore, the first layer $P_1$ forms a common capacitor electrode of the capacitors $C_1$, $C_2$, and so on, of the memory cells disposed in the same column. The second layer $P_2$ having an elongated hexagon shape forms the common gate electrodes of the transistors $Q_{11}$ and $Q_{12}$. As illustrated by a dotted line, each of the first layers $P_1$ is formed separately for every column and has square-shaped cut off portions E. In the conventional semiconductor device of Figure 3, the digit lines $DG_1$ and $DG_2$, which are connected to the drain or source electrode of the transistors $Q_{11}$ and $Q_{12}$, are constituted by a diffusion layer formed in the semiconductor substrate. Therefore, each of the first layers $P_1$ must be separated from each other in every column, in order to form the above-mentioned diffusion layers, i.e., the digit lines.

In the above-mentioned structure, the bias potential is always applied to the first layer $P_1$ in order to constitute the capacitors $C_1$ and $C_2$, i.e., in order to form an inversion layer on the surface of the semiconductor substrate, and electric charges are injected to the inversion layer according to the potential level of the input signal when the write-in of information is effected. When the read-out of information is effected, the transistors $Q_{11}$ and $Q_{12}$ are turned on by applying, for example, a high level voltage to the row line RL, so that the capacitors $C_1$ and $C_2$ are connected to the digit lines $DG_1$ and $DG_2$, respectively. Although they are not shown in the drawing, a large number of memory cells, therefore a large number of transistors each corresponding to the transistor $Q_{11}$ or $Q_{12}$, are connected to the row line RL. Therefore, when the above-mentioned high level voltage is applied to the row line RL, all the transistors connected to the row line RL are turned on and all the capacitors of the memory cells are connected to the corresponding digit lines. However, only one digit line is connected to the bus line by the column decoder so that only one of the memory cells is selected. For example, when the memory cell comprising the capacitor $C_1$ is selected, the digit line $DG_1$ is connected to the bus line.

In the aforementioned RAM device, each of the column decoders CD of Figure 2 corresponds to one of the sense amplifiers SA. When the RAM device comprises n sense amplifiers $SA_1$ through $SA_n$, as illustrated in Figure 1, the same number of column decoders, i.e., n column decoders CD are disposed along the array of the sense amplifiers. For example, in a 16 Kbit RAM device, if $m=n=128$, the number of the sense amplifiers SA and thus the number of the column decoders CD are both equal to 128. In the aforementioned conventional RAM device, the $m \times n$ bit memory cells are divided into two cell groups $CG_1$ and $CG_2$, as illustrated in Figure 1, so that m/2 memory cells are connected to each one of the digit lines which are connected to the sense amplifiers SA. Therefore, according to the increase of m, the length of each of the digit lines DG and $\overline{DG}$ increases, so that the stray capacitance $C_{DG}$ between each of the digit lines and the ground increases. As apparent from the aforementioned read out operation of the dynamic type RAM device, if the stray capacitance $C_{DG}$ is too large, the potential difference between the digit lines DG and $\overline{DG}$ in the read out status becomes small, so that the read out of information becomes very difficult. Assume that the precharge potential of the digit line DG is equal to $V_d$ and the capacitor $C_S$ of the selected memory cell MC is not charged. In this condition, the potential change $\Delta V_{SIG}$ of the digit line DG after the turn-on of the transistor $Q_1$ of the selected memory cell MC is as follows.

$$\Delta V_{SIG}=\frac{C_S}{C_S+C_{DG}}\cdot V_d \qquad (1)$$

The ratio of $C_{DG}$ to $C_S$, i.e., $C_{DG}/C_S$, is generally called a capacitance ratio $\gamma$. The formula (1) is expressed by using $\gamma$ as follows.

$$\Delta V_{SIG}=\frac{1}{1+\gamma}\cdot V_d \qquad (2)$$

The input voltages of the sense amplifier SA are the potential change $\Delta V_{SIG}$ of the digit line DG and the potential change $\Delta\overline{V}_{SIG}$ of the digit line $\overline{DG}$. If the capacitance of the capacitor $C_S'$ of the dummy cell DC is equal to a half of that of the capacitor $C_S$ of the real cell MC, the potential change $\Delta\overline{V}_{SIG}$ of the digit line $\overline{DG}$ is approximately equal to a half of the potential change $\Delta V_{SIG}$ of the digit line DG, because the capacitance ratio $\gamma$ is amply larger than 1. Therefore, the differential input voltage of the sense amplifier SA is as follows.

$$\Delta V_{SIG}-\Delta\overline{V}_{SIG}=\frac{1}{2}\cdot\frac{1}{1+\gamma}\cdot V_d \qquad (3)$$

In general, $V_d$ is approximately equal to 3V and $\gamma$ is approximately in the range between 10 through 15. Therefore, if $\gamma+1=10$, the differential input voltage of the sense amplifier SA is equal to 150 mV from the formula (3). Since the lower limit of the differential input voltage of the usual sense amplifier SA is approximately 100 mV, if $\gamma=10\sim15$, the read-out signal from the memory cell MC can easily be detected by the sense amplifier SA. It should be noted that this condition is satisfied only in the range $m\leqq128$, and the 16 K RAM device in which $m=n=128$ satisfies this condition. However, when the memory capacity of the RAM device having the arrangement of Figure 1 increases, for example, to 256 Kbit, i.e., $m=n=512$ and thus $m/2=256$, the stray capacitance $C_{DG}$ of the digit line DG increases and $\gamma\fallingdotseq40\sim60$. Therefore, the differential input voltage of the formula (3) becomes tens of mV, so that the sense amplifier cannot detect the differential input voltage.

In order to decrease the length of each of the digit lines DG in the RAM device having a large memory capacity, for example, 256 Kbit or more, it is possible to increase the number of the memory cells disposed along the row lines RL by increasing the length of the row lines RL and to decrease the number of the memory cells disposed along the digit lines DG. That is, instead of using the square-shaped cell matrix, in which m=n, the rectangular-shaped cell matrix, in which n>m, can be used. For example, in the 256 Kbit RAM device, if n=1024, m=256 or n=2048, m=128, the length of each of the digit lines DG can be decreased, so that the above-mentioned problem can be prevented. However, the shape of the semiconductor chip of such a RAM device becomes rectangularly elongated in accordance with the shape of the cell matrix, so that it is difficult to mount the semiconductor chip on a usual IC package which is designed to mount an approximately square-shaped semiconductor chip, and the mechanical strength of the semiconductor chip is decreased.

In order to solve the above-mentioned problems, arrangement in the RAM device illustrated in Figure 4 or Figure 5 makes it possible to decrease the number of the memory cells disposed along the digit lines and to make an approximately square-shaped memory chip. In Figure 4, n×m bits memory cells are divided into four cell groups, $CG_1$ through $CG_4$, each of which contains n×m/4 bit memory cells, and sense amplifier groups $SAG_1$, $SAG_2$ and column decoder groups $CDG_1$, $CDG_2$ are disposed between a pair of the cell groups $CG_1$ and $CG_2$ and between another pair of the cell groups $CG_3$ and $CG_4$. In Figure 5, n×m bit memory cells are divided into eight cell groups, $CG_1$ through $CG_8$, each of which contains n×m/8 bit memory cells, and the sense amplifier groups $SAG_1$ through $SAG_4$ and the column decoder groups $CDG_1$ through $CDG_4$ are disposed between each pair of the cell groups $CG_1$ and $CG_2$ through $CG_7$ and $CG_8$. In a 256 Kbit RAM device, the number of the memory cells connected to a digit line is m/4=128 in the arrangement of Figure 4 of m/8=64 in the arrangement of Figure 5, so that the aforementioned capacitance ratio $\gamma$ can be suppressed under 10 through 15. Therefore, even if the lower limit of the differential input voltage of each of the sense amplifiers in the sense amplifier groups $SAG_1$, $SAG_2$, ... is approximately 100 mV, the read-out signal from the memory cell can be detected.

However, the arrangements of Figure 4 and Figure 5, in which each of the column decoder groups $CDG_1$, $CDG_2$, ... is disposed along both sides of the respective one of the sense amplifier groups $SAG_1$, $SAG_2$, ... in the same manner to the arrangement of Figure 1, have several disadvantages which will now be explained with reference to Figure 6. Figure 6 illustrates a detailed structure of a part of the RAM device having the arrangement of Figure 4. In the area of the first cell group $CG_1$, m/4 row lines $RL_1$ through $RL_{m/4}$ which contain a dummy row line extend from the row address decoder (not shown in the drawing) in a transverse direction. Digit lines $\overline{DG}_1$, $\overline{DG}_2$, ... which extend from one side of each of the sense amplifiers $SA_1$, $SA_2$ respectively, ... of the first sense amplifier group $SAG_1$ intersect with the row lines $RL_1$ through $RL_{m/4}$, and an n×m/4 bit memory cell MC including a dummy cell are disposed at the cross points of these lines. In the area of the second cell group $CG_2$, m/4 row lines containing a dummy row line extend from the row address decoder (not shown in the drawing) in a transversal direction. At the cross points of the m/4 row lines and digit lines $DG_1$, $DG_2$, ... extending from the other side of each of the sense amplifiers $SA_1$, $SA_2$, ... of the first sense amplifier

group $SAG_1$, another n×m/4 bit memory cell including a dummy cell are disposed. A bit of read-out information from a memory cell selected from the cell groups $CG_1$ and $CG_2$ is transferred from the sense amplifier to bus lines $BUS_1$ and $\overline{BUS}_1$. The lower half portion of Figure 6 comprising the third memory cell group $CG_3$, the second sense amplifier group $SAG_2$ and the fourth memory cell group $CG_4$ has the same structure as that of the upper half portion of Figure 6 described above, and a bit of read-out information from a memory cell selected from the cell groups $CG_3$ and $CG_4$ is transferred to bus lines $BUS_2$ and $\overline{BUS}_2$.

As mentioned above, two column decoder groups $CDG_1$ and $CDG_2$ are used in the RAM device of Figure 6, that is, the first column decoder group $CDG_1$, consisting of the column decoders $CD_1$, $CD_2$, . . ., is used for the first sense amplifier group $SAG_1$, consisting of the sense amplifiers $SA_1$, $SA_2$, . . ., and the second column decoder group $CDG_2$, consisting of the column decoders $CD_1'$, $CD_2'$, . . ., is used for the second sense amplifier group $SAG_2$, consisting of the sense amplifiers $SA_1'$, $SA_2'$, . . . . It should be noted that, for example, the sense amplifier $SA_1$ which is selected by the column decoder $CD_1$ and the sense amplifier $SA_1'$ which is selected by the column decoder $CD_1'$, therefore, the digit lines $\overline{DG}_1$ and $DG_1$ and the digit lines $\overline{DG}_1'$ and $DG_1'$, belong to the same column on the m×n memory matrix. Therefore, the first column decoder group $CDG_1$ and the second column decoder group $CDG_2$ have the same structure and the same decoding function. Consequently, in the RAM device of Figure 4 or Figure 5, it is necessary to use a plurality of the column decoder groups having the same structure and the same decoding function, and thus the area occupied by the sense amplifiers and the column decoders on the semiconductor chip becomes large, so that the chip area cannot effectively be used for the memory cells. For example, in the RAM device having the arrangement of Figure 1, approximately 50% of the chip area can be used for the memory cells, but in the RAM device having the arrangement of Figure 4 or Figure 5, only about 40% or 30% of the chip area can be used for the memory cells. Moreover, in the RAM device having the arrangement of Figure 4 or Figure 5, since the number of the column decoders which are driven by column address buffers (not shown in the drawings) is large, the load capacitance of each of the column address buffers becomes large, so that the operating speed of the column address buffers is decreased.

In the proceedings of the IEEE International Solid-State Circuits Conference, Vol. 23, February 1980, pages 66—67, New York, a paper "A Stacked High Capacitor RAM" by K. Ohta et al. discloses a memory device which has a plurality of memory blocks each of which includes a sense amplifier array which comprises a plurality of sense amplifiers and a pair of memory cell groups each comprising a plurality of dynamic memory cells which are selectively connected to the sense amplifier array through digit lines. The device is provided with a row decoder for selecting a row line in the memory blocks and includes a plurality of pairs of bus lines, each pair corresponding to a respective one of the sense amplifier arrays. A column decoder, which is common to the plurality of memory blocks, selectively connects a pair of input/output terminals of a sense amplifier in each of the memory blocks to a corresponding one of the pairs of bus lines by controlling the potential of the column lines connected between the column decoder and the memory blocks. Each of the memory cells comprises a capacitor and an MOS transistor.

The Semiconductor Memory Book, 1978, pages 131—138, John Wiley and Sons, New York, "Designing with 16K Dynamic RAMS" by J. Coe describes a semiconductor memory device in which two memory blocks share a common column decoder which is disposed at the centre of the memory blocks.

It is an object of the present invention to provide a dynamic type semiconductor RAM device which has a large memory capacity and in which a greater portion of the chip are can be used for forming memory cells.

According to the present invention, there is provided a semiconductor memory device comprising a plurality of memory blocks each of which includes a sense amplifier array comprising a plurality of sense amplifiers and a pair of memory cell groups each comprising a plurality of dynamic type memory cells which are connected to the sense amplifier array through digit lines and each of which comprises a capacitor and an MOS transistor; a row decoder for selecting a row line in the plurality of memory blocks; pairs of bus lines, each pair corresponding to one of the sense amplifier arrays; and a column decoder which is common to the plurality of memory blocks and which selectively connects a pair of input/output terminals of the sense amplifier in each of the memory blocks to a corresponding one of the pairs of bus lines by controlling, the potential of the column lines connected between the column decoder and the plurality of memory blocks; characterised in that one of the electrodes of the capacitor is formed as a first conductive layer and the gate electrode of the MOS transistor is formed as a second conductive layer; in that the first conductive layer is formed continuously on a semiconductor substrate and constitutes a common electrode of the capacitors of all memory cells of the plurality of memory blocks; in that the digit lines are formed as a third conductive layer having a high electrical conductivity disposed on the first conductive layer with an insulation layer formed therebetween; in that the column lines are formed also as the third conductive layer; and in that the row lines are formed as a fourth layer having a high electrical conductivity disposed on the third conductive layer with another insulation layer formed therebetween.

An embodiment of the invention will now be described, by way of example, with reference to the accompanying drawings, in which:

Figure 1 illustrates an arrangement of circuit components on a semiconductor chip of a conventional dynamic-type RAM device;

Figure 2 illustrates a circuit of a main part of the RAM device of Figure 1;

Figure 3 illustrates a structure of a part of the RAM device of Figure 1;

Figure 4 and Figure 5 illustrate other examples of arrangements of circuit components on a semiconductor chip of a conventional dynamic-type RAM device having a large memory capacity;

Figure 6 illustrates a circuit of a main part of the RAM device of Figure 4;

Figure 7 illustrates an arrangement of circuit components on a semiconductor chip of a large capacity dynamic-type RAM device as an embodiment of the present invention;

Figure 8 illustrates a circuit of a main part of the RAM device of Figure 7;

Figure 9 illustrates a structure of a part of the RAM device of Figure 7, and

Figure 10 illustrates a cross-section of the RAM device of Figure 9 taken on a line A—A' thereof.

Figure 7 illustrates a schematic arrangement of circuit components of a dynamic-type RAM device as employed in the present invention and Figure 8 illustrates a detailed circuit of a part of the dynamic type RAM device of Figure 7. The RAM device of Figure 7 and Figure 8 has, as the RAM device of Figure 4 and Figure 6, n×m bit memory cells which are divided into four cell groups $CG_1$ through $CG_4$. In Figure 7 and Figure 8, the same parts as appear in Figure 4 and Figure 6 are designated by the same reference symbols. The RAM device according to Figures 7 and 8 differs from that of Figure 4 and Figure 6 in the following points. The RAM device according to Figures 7 and 8 does not comprise a plurality of column decoder groups disposed along with each of the sense amplifier groups $SAG_1$ and $SAG_2$, but comprises a single common column decoder group CDG disposed parallel to the sense amplifier groups $SAG_1$ and $SAG_2$, for example, outside of the area of the sense amplifier groups $SAG_1$ and $SAG_2$ and the cell groups $CG_1$ through $CG_4$. The sense amplifier group $SAG_1$ and the cell groups $CG_1$ and $CG_2$ disposed on both sides of the sense amplifier group $SAG_1$ constitute a first memory block $MB_1$ and the sense amplifier group $SAG_2$ and the cell groups $CG_3$ and $CG_4$ disposed on both sides of the sense amplifier group $SAG_2$ constitute a second memory block $MB_2$. From each of the column decoders $CD_1$, $CD_2$, ... in the column decoder group CDG, column select lines, i.e., column lines $CL_1$, $CL_2$, ... are extended through the memory blocks $MB_1$ and $MB_2$ so that each of the column decoders $CD_1$, $CD_2$, ... can select a plurality of, i.e., two sense amplifiers of the sense amplifier groups $SAG_1$ and $SAG_2$ belonging to the same column, for example $SA_1$ and $SA_1'$, at the same time. Each of the column lines $CL_1$, $CL_2$, ... can be formed as a multilayer connecting lead on the area of the memory cells on a semiconductor chip, and each is connected to the gate electrodes of the gate transistors such as $Q_2$, $Q_3$ and $Q_2'$, $Q_3'$ which belong to the same column. In the arrangement of Figure 7 and Figure 8, the common column decoder group CDG is disposed at the outside edge of the memory blocks $MB_1$ and $MB_2$. However, it should be noted that the common column decoder group CDG can also be disposed between the memory blocks $MB_1$ and $MB_2$ and parallel to the sense amplifier groups $SAG_1$ and $SAG_2$. When the common column decoder group CDG is disposed at the center of the memory blocks $MB_1$ and $MB_2$, a delay time in transmitting a signal caused by the stray capacitance of column line $CL_1$, $CL_2$ is equal to that of the arrangement of Figure 7 and Figure 8. The other portions of the RAM device of Figure 7 and Figure 8 are the same as those of the RAM device of Figure 4 and Figure 6 and, therefore, the explanation thereof is omitted here.

In the RAM device having the above-mentioned arrangement, the larger part of the chip area can be used for forming the memory cells, or the size of the total chip area can be decreased more than in the RAM device of Figure 4 and Figure 6. This is because, the RAM device according to Figures 7 and 8 uses only a single column decoder group, so that even if the number of the sense amplifier groups increases and, therefore, even if the number of the cell groups increases according to the increase in the memory capacity of the RAM device, the column decoder group does not occupy a large area on the semiconductor chip. Moreover, in the RAM device according to Figures 7 and 8, if the chip size is equal to that of the RAM device of Figures 4 and 6, the size of each of the memory cells can be larger than that of the RAM device of Figures 4 and 6, so that the capacitor $C_S$ in each of the memory cells can be larger and the differential input voltage of each of the sense amplifiers can be larger. Therefore, the design of the sense amplifiers is not difficult, even if the memory capacity of the RAM device is increased. Since the load of column address buffers is only one column address decoder group CDG, the load capacitance of the column address buffers is decreased and the operating speed of the column address buffers can be increased. Moreover, in the RAM device of Figures 7 and 8, each of the digit lines does not pass through the column decoders and, therefore, the length of each of the digit lines is decreased, so that the stray capacitance thereof becomes small.

Since, in the above-mentioned arrangement, two sense amplifiers in the same column, for example $SA_1$ and $SA_1'$ are selected at the same time, output signals from both memory blocks $MB_1$ and $MB_2$, respectively, appear on the bus lines $BUS_1$, $\overline{BUS}_1$ and $BUS_2$, $\overline{BUS}_2$ at the same time. However, as illustrated in Figure 8, one of these signals is selected by, for example, gate transistors $Q_5$, $Q_6$ and $Q_5'$, $Q_6'$ and bus decoders $BSD_1$ and $BSD_2$ and supplied to an input/output amplifier IOA through data bus lines $\overline{DB}$ and DB, so that the output signal $D_{OUT}$ from one selected memory cell is derived. Each of the bus decoders $BSD_1$ and $BSD_2$ is operated by a part of row address signals and turns on the gate transistors $Q_5$, $Q_6$ or $Q_5'$, $Q_6'$ in order to connect the bus lines $\overline{BUS_1}$, $BUS_1$ or $\overline{BUS_2}$, $BUS_2$ to the data buses $\overline{DB}$, DB. For example, in the RAM device of Figure 7 in which n×m bit memory cells are divided into four cell groups $CG_1$ through $CG_4$, the row decoders RD are operated by the N-1 bit of row address signals and the bus decoder is operated by a remaining one bit of the row address signals, where N is a total bit number of the row address signals or the column address signals, i.e., $2^N=m=n$. In this case, the column decoder group CDG is operated by N bits of the column address signals.

In the above, the RAM device, in which the memory cells are divided into four cell groups $CG_1$ through $CG_4$, is explained. However, it should be noted that the present invention can be adapted to the RAM device in which the memory cells are divided into eight cell groups, as in the RAM device of Figure 5, or into another number of cell groups.

As apparent from the above description, in the RAM device according to Figures 7 and 8, it is necessary for the column lines $CL_1$, $CL_2$, ... to pass through the memory areas, for example, $MB_1$ and $MB_2$. However, if the conventional structure of Figure 3 is used, it is impossible to pass the column lines $CL_1$, $CL_2$, ... through the area of the memory cells in parallel to each of the digit lines $DG_1$, $DG_2$, ..., because, as apparent from Figure 3, the area between each of the digit lines $DG_1$, $DG_2$, ... is tightly filled with the capacitors and the transistors of each of the memory cells. Moreover, in the conventional structure of Figure 3, each of the digit lines $DG_1$, $DG_2$, ... is formed by the diffusion layer, so that it is necessary to have a relatively large distance G between an edge $CE_1$ or $CE_2$ of the capacitor $C_1$ or $C_2$ and the digit line $DG_2$ or $DG_1$ corresponding to the other capacitor $C_2$ or $C_1$, respectively, in order to avoid a short circuit therebetween. If the interval between each of the digit lines is decreased in order to increase the packing density of the memory cells, the capacitance of the capacitor $C_1$ or $C_2$ becomes small and the differential input voltage of each of the sense amplifiers becomes small, so that it is difficult to detect information from the memory cell. Since the stray capacitance between each of the digit lines and the ground is relatively large, due to the existence of the junction capacitance between the diffusion layer and the semiconductor substrate having the opposite conductivity to that of the diffusion layer, the number of the memory cells which can be connected to one digit line is decreased. This is because, since the magnitude of the output voltage from the memory cell depends on the capacitance ratio $C_{DG}/C_S$, as mentioned before, the differential input voltage to each of the sense amplifiers is decreased, so that it is necessary to decrease the number of the memory cells connected to one digit line. As a result, the structure of Figure 3 is not suitable for the RAM device having a large memory capacity according to Figures 7 and 8.

Figure 9 illustrates a part of a structure of the RAM device in accordance with the present invention for the dynamic-type RAM device having a large memory capacity according to Figures 7 and 8, and Figure 10 is a cross-sectional view of the structure of Figure 9 taken on line A-A'. In Figures 9 and 10, the same circuit portions as appear in Figure 3 are designated by the same reference symbols. In the RAM device of Figure 9 and Figure 10, digit lines $DG_1$, $DG_2$, ... are formed, not as a diffusion layer, but as another conducting layer on a semiconductor substrate SUB, and a polysilicon layer $P_1$, i.e., a first conductive layer is formed as a thin film which is not separated by the digit lines $DG_1$, $DG_2$, ... and is common to all columns and which has windows W only in the area illustrated by dotted lines in which memory cell transistors $Q_{11}$, $Q_{12}$, ... are formed. Also in the RAM device of Figures 9 and 10, each of the column lines CL is disposed parallel to the digit lines $DG_1$, $DG_2$, ... on the area in which the memory cells are formed. Each of the row lines RL which are connected to a second conductive layer $P_2$ at a contact hole $CH_1$, is formed as a conductive layer made of a material having a high electrical conductivity such as aluminum, this conductive layer is a fourth layer formed on the digit lines $DG_1$, $DG_2$, ... and each of the column lines CL. Therefore, the RAM device of Figures 9 and 10, according to the present invention, has a four layer structure consisting of the first conductive layer $P_1$ which constitutes a common electrode of the memory capacitors $C_1$, $C_2$, ..., the second conductive layer $P_2$ which is the gate electrode of each of the memory cell transistors $Q_{11}$, $Q_{12}$, ..., the third conductive layer which is the conductive layer having a high electrical conductivity and the fourth conductive layer which forms the row lines RL. The digit lines $DG_1$, $DG_2$, ... and the column lines $CL_1$, $CL_2$, ... are formed as the third conductive layer having a high electrical conductivity and are disposed in the direction perpendicular to the row lines RL of the fourth conductive layer. The third conductive layer having a high electrical conductivity is made of a metal having a high melting point, such as molybdenum or tungsten or silicate with such metal, or is made of polysilicon or aluminum. The digit lines $DG_1$, $DG_2$, ... of the third conductive layer are formed on a first insulation layer $I_1$ which covers the first conductive layer $P_1$ and the second conductive layer $P_2$ except for the portions of the contact holes $CH_2$, $CH_3$, ... through which the digit lines $DG_1$, $DG_2$, ... of the third conductive layer are respectively connected to $n^+$ layers, i.e., the drain or source electrodes of the transistors $Q_{11}$, $Q_{12}$, .... The digit lines $DG_1$, $DG_2$, ... are covered with a second insulation layer $I_2$ formed thereon and the row lines RL are formed on the second insulation layer $I_2$. Although none

of the row lines RL exist on a line A-A' of Figure 9, Figure 10 includes an illustration of the row line RL in order to clarify the explanation. The first and second insulating layers $I_1$ and $I_2$ are formed of, for example, a PSG (Phosphosilicate Glass) film, a silicon nitride ($Si_3N_4$) film or a silicon oxide ($SiO_2$) film made by the CVD (Chemical Vapor Deposition) method. In Figure 10, IL is an inversion layer which forms a capacitor $C_1$ or an impurity layer in which impurities having a reverse conductivity type are doped by the ion implantation technique. $OX_1$ and $OX_2$ are thin layers ($SiO_2$) formed between the substrate SUB and the first conductive layer $P_1$ and between the substrate SUB and the second conductive layer $P_2$. $OX_3$ is an insulating layer ($SiO_2$) formed between the first conductive layer $P_1$ and the second conductive layer $P_2$ and between the first conductive layer $P_1$ and the first insulation layer $I_1$.

In the above-mentioned device structure according to the present invention, none of the digit lines $DG_1$, $DG_2$, . . . is formed as a diffusion layer, so that it is unnecessary to dispose the separation area G of the conventional RAM device of Figure 3. Therefore, each of the edges $CE_1$, $CE_2$, . . . of the capacitors $C_1$, $C_2$, . . . can be disposed adjacently to the respective one of the digit lines $DG_1$, $DG_2$, . . . . Therefore, the area of each of the capacitors $C_1$, $C_2$, . . . can be larger than that of the conventional RAM device of Figure 3, if the interval between the digit lines is equal to that of the conventional RAM device of Figure 3, so that the differential input voltage to each of the sense amplifiers can be increased and design of the sense amplifiers is not difficult, even if the memory capacity is increased. If, in the RAM device according to the present invention, the area of each of the capacitors $C_1$, $C_2$, . . . is equal to that of the conventional RAM device of Figure 3, it is possible to reduce the interval between the digit lines $DG_1$, $DG_2$, . . ., so that the integration degree and therefore the memory density of the RAM device can be larger. Since each of the digit lines $DG_1$, $DG_2$, . . . is not a diffusion layer and there exists the first conductive layer $P_1$ and the first insulation layer $I_1$ between the digit lines $DG_1$, $DG_2$, . . . and the semiconductor substrate SUB, the stray capacitance of each of the digit lines can be small. Therefore, it is possible to increase the differential input voltage of each of the sense amplifiers when the number of the memory cells connected to one digit line is the same as that of the conventional RAM device of Figure 3. As mentioned above, the column lines CL are formed as a third conductive layer, which includes the digit lines $DG_1$, $DG_2$, . . . . Therefore, it is possible to form the column lines CL, which extend from the common column decoder group CDG disposed, for example, at the outer edge of the memory block $MB_2$ as shown in Figure 7, at the same time as the digit lines $DG_1$, $DG_2$, . . . in the manufacturing process of the RAM device, so that the manufacturing process of the column lines can be simplified.

As apparent from the above explanation, since the MOS dynamic-type RAM device according to the present invention uses a single column decoder group, even when the memory cells are divided into four or more cell groups, and since the RAM device according to the present invention has a four-layer structure, the greater portion of the chip area can be used for forming the memory cells and the differential input voltage of each of the sense amplifiers does not decrease, even when the memory capacity is very large.

## Claims

1. A semiconductor memory device comprising a plurality of memory blocks (MB) each of which includes a sense amplifier array (SAG) comprising a plurality of sense amplifiers (SA) and a pair of memory cell groups (CG) each comprising a plurality of dynamic type memory cells which are connected to the sense amplifier array through digit lines (DG, $\overline{DG}$) and each of which comprises a capacitor and an MOS transistor; a row decoder (RD) for selecting a row line (RL) in the plurality of memory blocks; pairs of bus lines (BUS, $\overline{BUS}$), each pair corresponding to one of the sense amplifier arrays; and a column decoder (CDG) which is common to the plurality of memory blocks and which selectively connects a pair of input/output terminals of the sense amplifier in each of the memory blocks to a corresponding one of the pairs of bus lines by controlling the potential of the column lines (CL) connected between the column decoder and the plurality of memory blocks; characterised in that one of the electrodes of the capacitor is formed as a first conductive layer ($P_1$) and the gate electrode of the MOS transistor is formed as a second conductive layer ($P_2$); in that the first conductive layer ($P_1$) is formed continuously on a semiconductor substrate (SUB) and constitutes a common electrode of the capacitors of all memory cells of the plurality of memory blocks (MB); in that the digit lines are formed as a third conductive layer having a high electrical conductivity disposed on the first conductive layer with an insulation layer ($I_1$) formed therebetween; in that the column lines are formed also as the third conductive layer; and in that the row lines are formed as a fourth layer having a high electrical conductivity disposed on the third conductive layer with another insulation layer ($I_2$) formed therebetween.

2. A device as claimed in claim 1, characterised in that the column decoder (CDG) is disposed along an outside edge of the area of the memory blocks (MB).

3. A device as claimed in claim 1, characterised in that the column decoder (CDG) is disposed between the memory blocks (MB).

4. A device as claimed in claim 3, characterised in that the column decoder (CDG) is disposed at the centre of the memory blocks (MB).

5. A device as claimed in claim 1, characterised in that the column lines (CL) from the column decoder (CDG) pass through the area of the memory blocks (MB).

6. A device as claimed in claim 5, characterised in that the column lines (CL) are connected to gate transistors ($Q_2$, $Q_3$) which selectively connect the pair of input/output terminals of the sense amplifier in each of the memory blocks (MB) to a corresponding one of the pairs of bus lines (BUS, $\overline{BUS}$).

7. A device as claimed in claim 1, characterised in that each of the pairs of bus lines (BUS, $\overline{BUS}$) is disposed parallel to the sense amplifier array (SAG) of a corresponding one of the memory blocks (MB).

8. A device as claimed in any preceding claim, characterised in that the first conductive layer ($P_1$) is made of polycrystalline silicon.

9. A device as claimed in any preceding claim, characterised in that the second conductive layer ($P_2$) is made of polycrystalline silicon.

10. A device as claimed in any preceding claim, characterised in that the third conductive layer is made of metal having a high melting point, or a silicate with metal having a high melting point, or polycrystalline silicon or aluminium.

**Patentansprüche**

1. Halbleiterspeicheranordnung, mit einer Vielzahl von Speicherblöcken (MB), die jeweils eine Leseverstärkeranordnung (SAG) mit einer Vielzahl von Leseverstärkern (SA) und einem Paar von Speicherzellengruppen (CG) umfassen, die jeweils eine Vielzahl von dynamischen Speicherzellen umfassen, welche mit der Leseverstärkeranordnung über Stellenleitungen (DG, $\overline{DG}$) verbunden sind und von denen jede einen Kondensator und einen MOS-Transistor umfaßt;

einem Reihendecoder (RD), zum Auswählen einer Reihenleitung (RL) in der Vielzahl von Speicherblöcken;

Paaren von Busleitungen (BUS, $\overline{BUS}$), von denen jedes Paar einer der Leseverstärkeranordnungen entspricht,

und einem Spaltendecoder (CDG), welcher der Vielzahl von Speicherblöcken gemeinsam ist und welcher selektiv ein Paar von Eingangs/Ausgangs-Anschlüssen des Leseverstärkers in jedem der Speicherblöcke mit einem entsprechenden der Paare von Busleitungen verbindet, durch Steuerung des Potentials der Spaltenleitungen (CL), welche zwischen dem Spaltendecoder und der Vielzahl von Speicherblöcken angeordnet sind;

dadurch gekennzeichnet, daß eine der Elektroden des Kondensators als eine erste leitende Schicht ($P_1$) und die Gateelektrode des MOS-Transistors als eine zweite leitende Schicht ($P_2$) gebildet ist;

daß die erste leitende Schicht ($P_1$) kontinuierlich auf einem Halbleitersubstrat (SUB) geformt ist und eine gemeinsame Elektrode der Kondensatoren aller Speicherzellen der Vielzahl von Speicherblöcken (MB) ist;

daß die Stellenleitungen als eine dritte leitende Schicht gebildet sind, welche eine hohe elektrische Leitfähigkeit hat und auf der ersten leitenden Schicht, mit einer isolierenden Schicht ($I_1$) dazwischen ausgebildet, angeordnet ist,

daß die Spaltenleitungen ebenfalls als die dritte leitende Schicht geformt sind;

und daß die Reihenleitungen als eine vierte leitende Schicht gebildet sind, welche eine hohe elektrische Leitfähigkeit hat und auf der dritten leitenden Schicht, mit einer anderen Isolierschicht ($I_2$) dazwischen ausgebildet, angeordnet ist.

2. Vorrichtung nach Anspruch 1, dadurch gekennzeichnet, daß der Spaltendecoder (CDG) längs einer Außenkante des Bereichs der Speicherblöcke (MB) angeordnet ist.

3. Vorrichtung nach Anspruch 1, dadurch gekennzeichnet, daß der Spaltendecoder (CDG) zwischen den Speicherblöcken (MB) angeordnet ist.

4. Vorrichtung nach Anspruch 3, dadurch gekennzeichnet, daß der Spaltendecoder (CDG) an dem Zentrum der Speicherblöcke (MB) ausgebildet ist.

5. Vorrichtung nach Anspruch 1, dadurch gekennzeichnet, daß die Spaltenleitungen (CL) des Spaltendecoders (CDG) durch den Bereich der Speicherblöcke (MB) hindurchführen.

6. Vorrichtung nach Anspruch 5, dadurch gekennzeichnet, daß die Spaltenleitungen (CL) mit den Gatetransistoren ($Q_2$, $Q_3$) verbunden sind, welche wahlweise das Paar von Eingangs/Ausgangs-Anschlüssen des Leseverstärkers in jedem der Speicherblöcke (MB) mit einem entsprechenden der Paare von Busleitungen (BUS, $\overline{BUS}$) verbinden.

7. Vorrichtung nach Anspruch 1, dadurch gekennzeichnet, daß jedes der Paare von Busleitungen (BUS, $\overline{BUS}$) parallel zu der Leseverstärkeranordnung (SAG) eines entsprechenden der Speicherblöcke (MB) angeordnet ist.

8. Vorrichtung nach einem der vorhergehenden Ansprüche, dadurch gekennzeichnet, daß die erste leitende Schicht ($P_1$) aus polykristallinem Silizium besteht.

9. Vorrichtung nach einem der vorhergehenden Ansprüche, dadurch gekennzeichnet, daß die zweite leitende Schicht ($P_2$) aus polykristallinem Silizium hergestellt ist.

10. Vorrichtung nach einem der vorhergehenden Ansprüche, dadurch gekennzeichnet, daß die dritte leitende Schicht aus einem Metall hergestellt ist, das einen hohen Schmelzpunkt hat, oder aus einem Silikat mit Metall, welches einen hohen Schmelzpunkt hat, oder aus polykristallinem Silizium oder Aluminium.

**Revendications**

1. Dispositif de mémoire à semi-conducteurs comportant plusieurs blocs de mémoire (MB) dont chacun comporte un groupe d'identificateurs de détection (SAG) comprenant plusieurs amplificateurs de détection (SA) et une paire de groupes de cellules de mémoire (CG) comprenant chacun plusieurs cellules de mémoire de type dynamique qui sont connectées au groupe d'amplificateurs de détection par des lignes de chiffres (DG, $\overline{DG}$) et dont chacune comporte un condensateur et un transistor MOS; un décodeur de rangée (RD) pour sélectionner une ligne de rangée (RL) dans les plusieurs blocs de mémoire, des paires de lignes omnibus (BUS, $\overline{BUS}$) chaque paire correspondant à l'un des groupes d'amplificateurs de détection; et un décodeur de colonnes (CDG) qui est commun aux plusieurs blocs de mémoire et qui connecte sélectivement une paire de bornes d'entrée/sortie de l'amplificateur de détection de chacun des blocs de mémoire à l'une correspondante des paires de lignes omnibus en commandant le potentiel des lignes de colonnes (CL) connectées entre le décodeur de colonnes et les plusieurs blocs de mémoire, caractérisé en ce que l'une des électrodes du condensateur est formée comme une première couche conductrice (P1) et l'électrode de grille du transistor MOS est formée comme une seconde couche conductrice (P2); en ce que la première couche conductrice (P1) est formée de façon continue sur un substrat semi-conducteur (SUB) et constitue une électrode commune des condensateurs de toutes les cellules de mémoire des blocs de mémoire (MB); en ce que les lignes de chiffres sont formées comme une troisième couche conductrice ayant une haute conductivité électrique, disposée sur la première couche conductrice avec une couche isolante (I1) formée entre elles, en ce que les lignes de colonnes sont formées également comme la troisième couche conductrice; et en ce que les lignes de rangées sont formées comme une quatrième couche ayant une haute conductivité électrique, disposée sur la troisième couche conductrice avec une autre couche isolante (I2) formée entre elles.

2. Dispositif selon la revendication 1, caractérisé en ce que le décodeur de colonnes (CDG) est disposé le long d'un bord extérieur de la région des blocs de mémoire (MB).

3. Dispositif selon la revendication 1, caractérisé en ce que le décodeur de colonnes (CDG) est disposé entre les blocs de mémoire (MB).

4. Dispositif selon la revendication 3, caractérisé en ce que le décodeur de colonnes (CDG) est disposé au centre des blocs de mémoire (MB).

5. Dispositif selon la revendication 1, caractérisé en ce que les lignes de colonnes (CL) provenant du décodeur de colonnes (CDG) passe par la région des blocs de mémoire (MB).

6. Dispositif selon la revendication 5, caractérisé en ce que les lignes de colonnes (CL) sont connectées à des transistors d'aiguillage (Q2, Q3) qui connectent sélectivement la paire de bornes d'entrée/sortie de l'amplificateur de détection de chacun des blocs de mémoire (MB) à l'une correspondante des paires de lignes omnibus (BUS, $\overline{BUS}$).

7. Dispositif selon la revendication 1, caractérisé en ce que chacune des paires de lignes omnibus (BUS, $\overline{BUS}$) est disposée parallèlement au groupe d'amplificateurs de détection (SAG) de l'un correspondant des blocs de mémoire (MB).

8. Dispositif selon l'une quelconque des revendications précédentes, caractérisé en ce que la première couche conductrice (P1) est faite de silicium polycristallin.

9. Dispositif selon l'une quelconque des revendications précédentes, caractérisé en ce que la seconde couche conductrice (P2) est faite de silicium polycristallin.

10. Dispositif selon l'une quelconque des revendications précédentes, caractérisé en ce que la troisième couche conductrice est faite d'un métal à haut point de fusion ou d'un silicate avec un métal ayant un haut point de fusion ou de silicium polycristallin ou d'aluminium.

Fig. 1

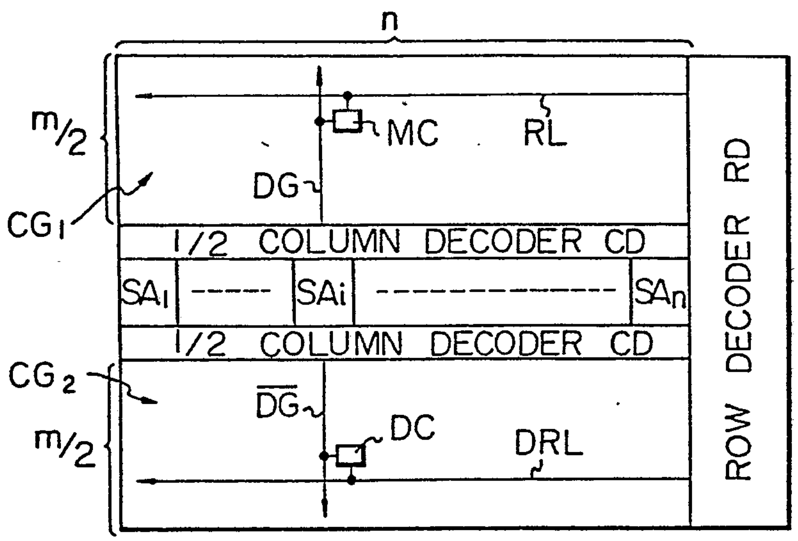
n
m/2
CG1
MC
RL
DG
1/2 COLUMN DECODER CD
SA1
SAi
SAn
1/2 COLUMN DECODER CD
CG2
m/2
DG
DC
DRL
ROW DECODER RD

Fig. 2

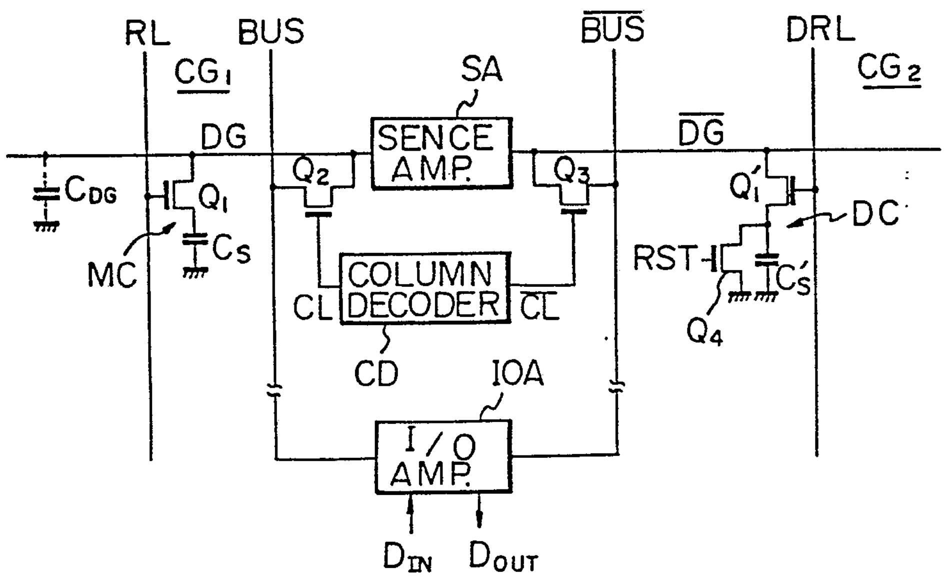
RL
BUS
BUS
DRL
CG1
SA
CG2
DG
SENCE AMP.
DG
CDG
Q1
Q2
Q3
Q1'
DC
MC
Cs
COLUMN DECODER
RST
Cs'
CL
CL
Q4
CD
IOA
I/O AMP.
DIN
DOUT

Fig. 3

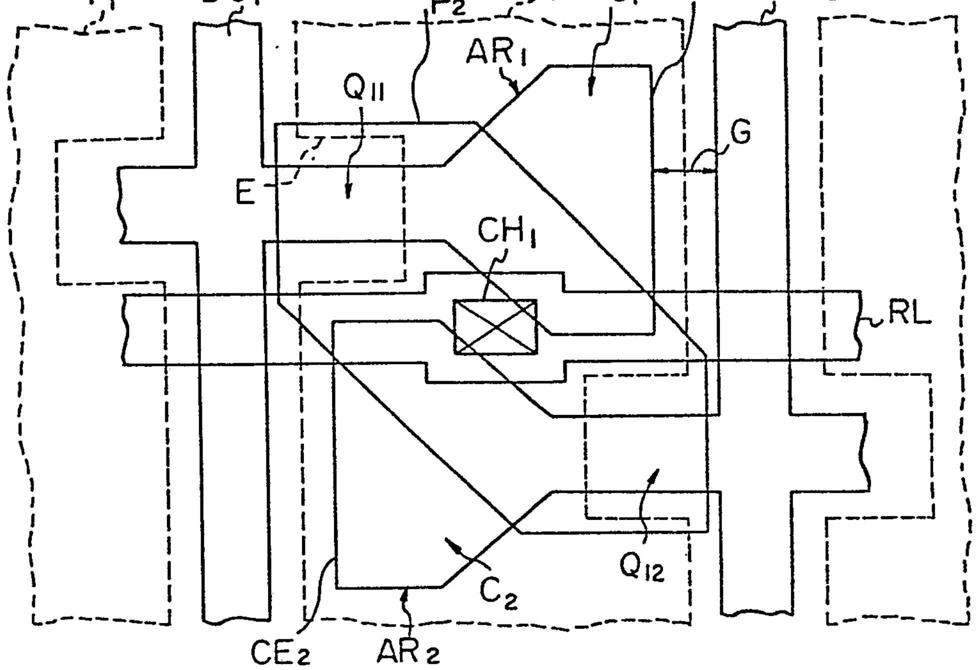
P1
DG1
P2
P1
C1
CE1
DG2
AR1
Q11
G
E
CH1
RL
Q12
C2
CE2
AR2

Fig. 7

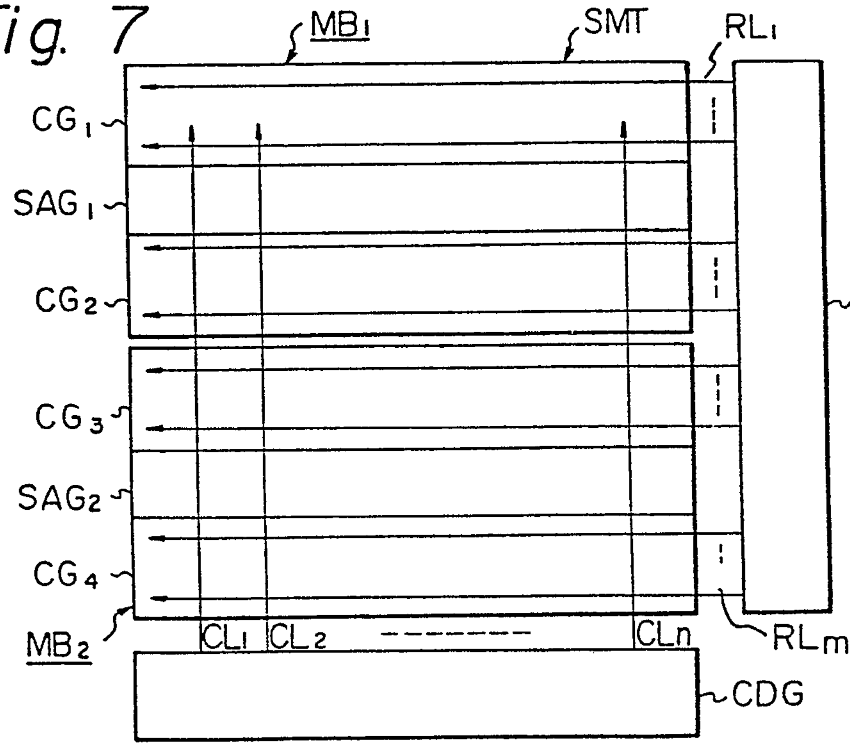
MB1
SMT
RL1
CG1
SAG1
CG2
RD
CG3
SAG2
CG4
MB2
CL1
CL2
CLn
RLm
CDG

Fig. 4

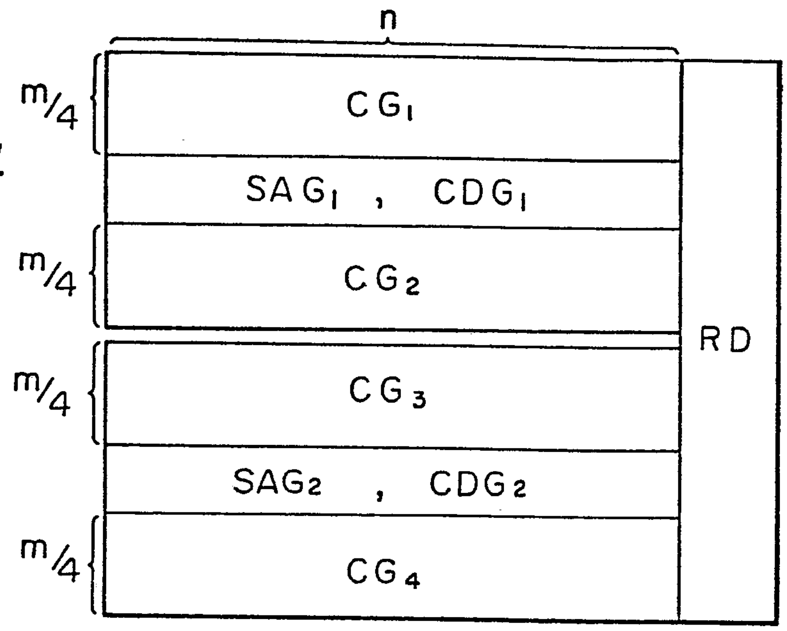
n
m/4
CG1
SAG1 , CDG1
m/4
CG2
m/4
CG3
SAG2 , CDG2
m/4
CG4
RD

Fig. 5

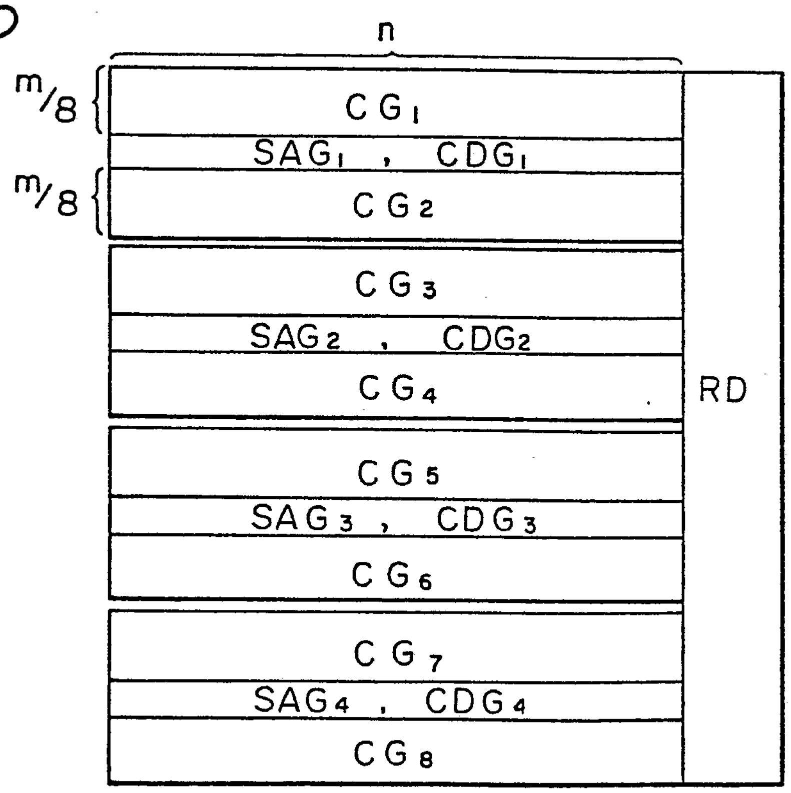
n
m/8
CG1
SAG1 , CDG1
m/8
CG2
CG3
SAG2 , CDG2
CG4
CG5
SAG3 , CDG3
CG6
CG7
SAG4 , CDG4
CG8
RD

Fig. 6

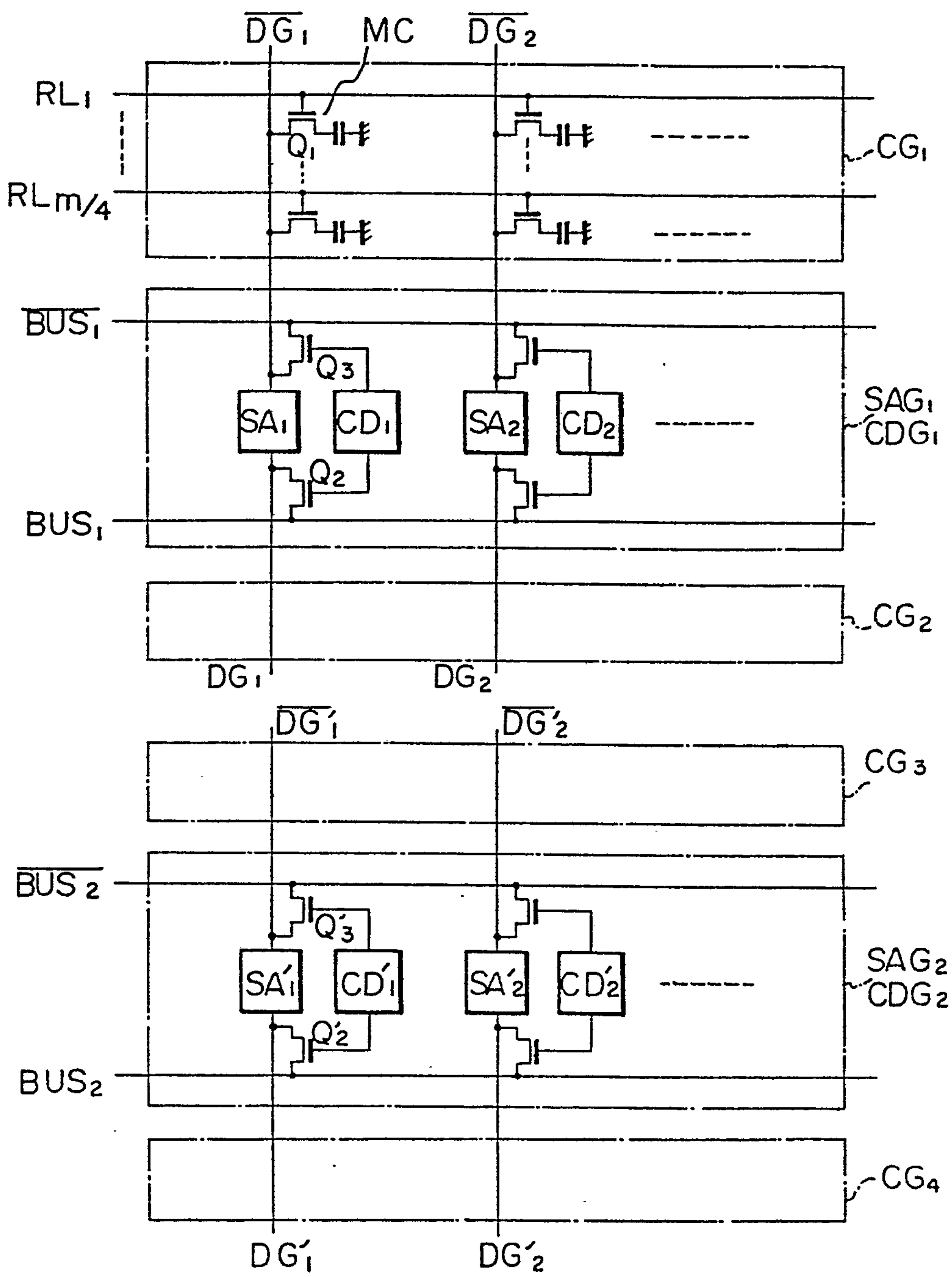
DG1
MC
DG2
RL1
RLm/4
Q1
CG1
BUS1
Q3
SA1
CD1
SA2
CD2
SAG1
CDG1
Q2
BUS1
CG2
DG1
DG2
DG'1
DG'2
CG3
BUS2
Q'3
SA'1
CD'1
SA'2
CD'2
SAG2
CDG2
Q'2
BUS2
CG4
DG'1
DG'2

Fig. 8

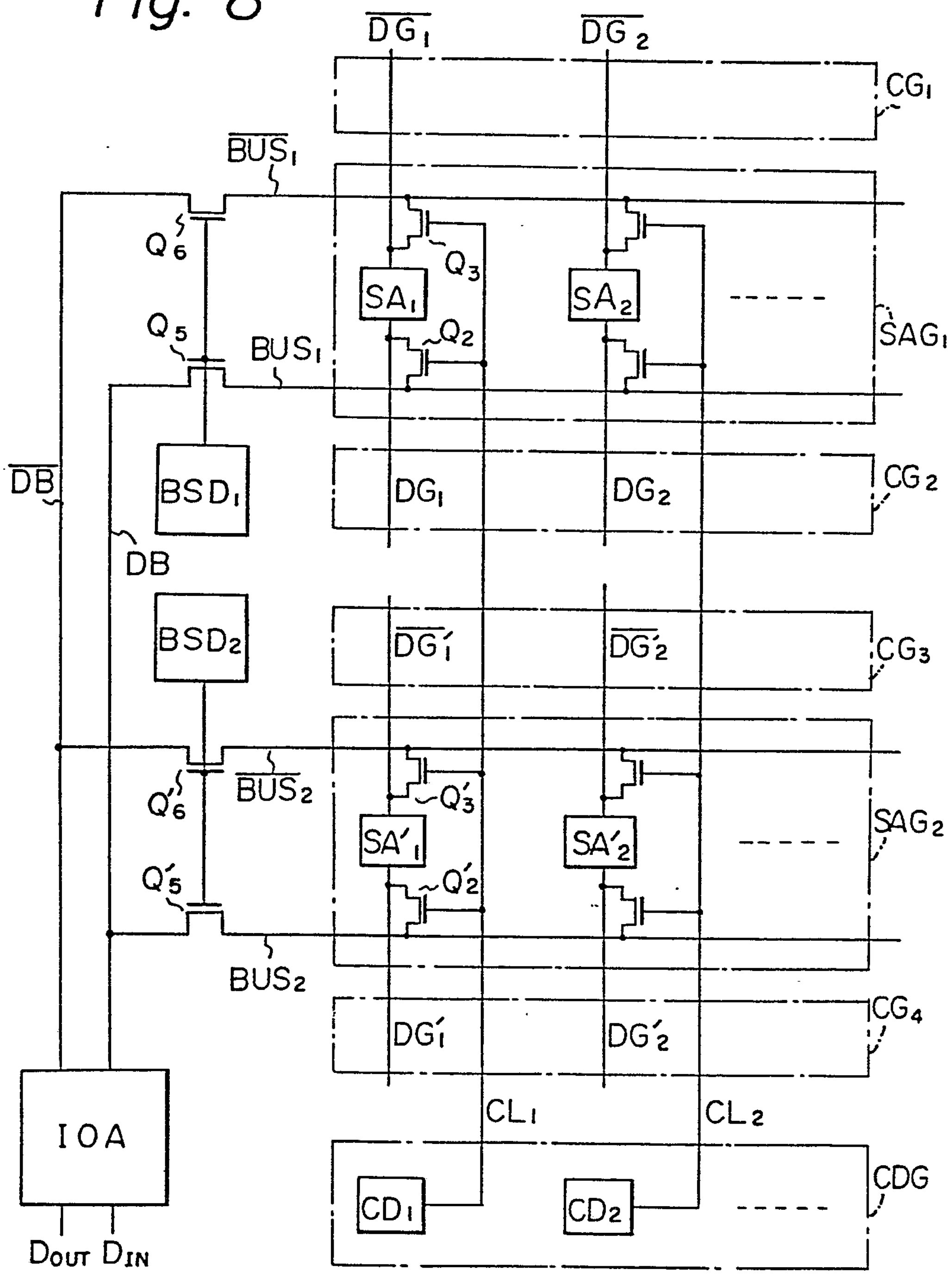

DG1
DG2
CG1
BUS1
Q6
Q3
SA1
SA2
Q5
Q2
BUS1
SAG1
DB
BSD1
DG1
DG2
CG2
DB
BSD2
DG'1
DG'2
CG3
Q'6
BUS2
Q'3
SA'1
SA'2
SAG2
Q'5
Q'2
BUS2
DG'1
DG'2
CG4
CL1
CL2
IOA
CD1
CD2
CDG
DOUT
DIN

Fig. 9

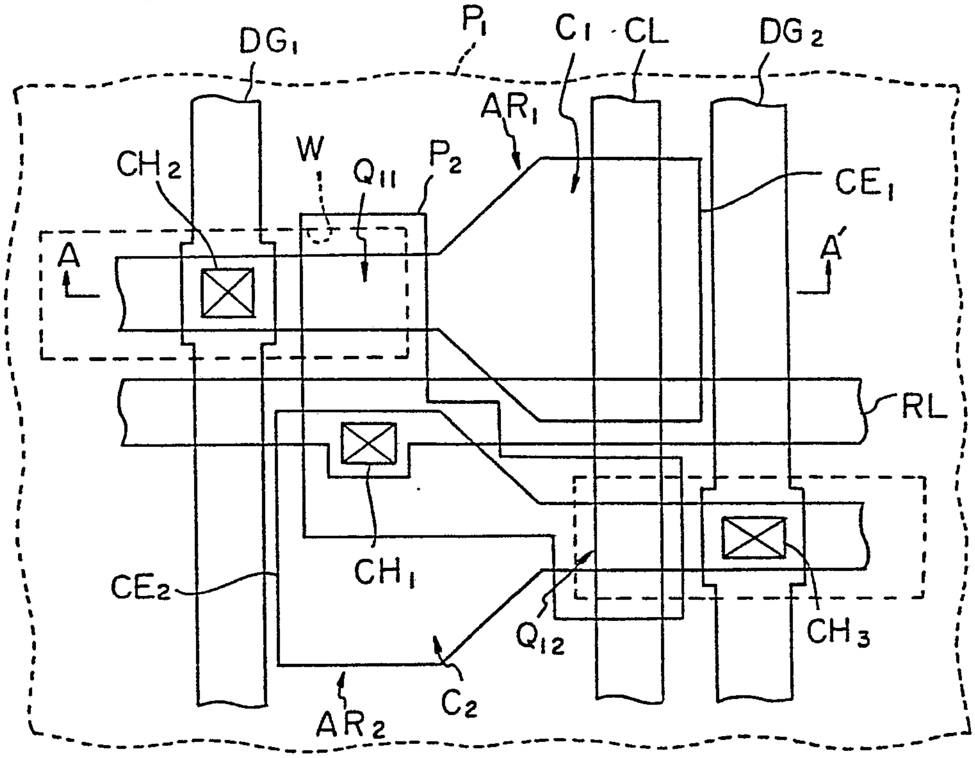
DG1
P1
C1 · CL
DG2
AR1
CH2
W
Q11
P2
CE1
A
A'
RL
CH1
CE2
Q12
CH3
C2
AR2

Fig. 10

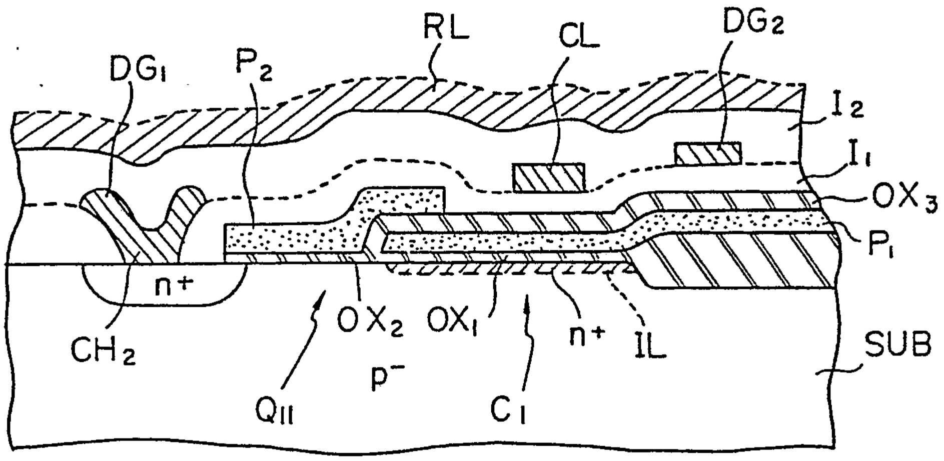
RL
CL
DG2
DG1
P2
I2
I1
OX3
P1
n+
CH2
OX2
OX1
n+
IL
SUB
Q11
p−
C1